## Europäisches Patentamt

## European Patent Office

## Office européen des brevets

(11) Veröffentlichungsnummer: **0 129 154**
A2

# (12) EUROPÄISCHE PATENTANMELDUNG

(21) Anmeldenummer: **84106501.4**

(22) Anmeldetag: **07.06.84**

(51) Int. Cl.³: **H 03 J 5/24**
**H 03 B 5/12**

(30) Priorität: **16.06.83 DE 3321725**

(43) Veröffentlichungstag der Anmeldung:
**27.12.84 Patentblatt 84/52**

(84) Benannte Vertragsstaaten:
**AT FR GB IT NL**

(71) Anmelder: **TELEFUNKEN electronic GmbH**
**Theresienstrasse 2**
**D-7100 Heilbronn(DE)**

(72) Erfinder: **Heigl, Franz**
**Frühlingsstrasse 12**
**D-8079 Ochsenfeld(DE)**

(72) Erfinder: **Rehm, Josef**
**Perusastrasse 32**
**D-8069 Rohrbach(DE)**

(74) Vertreter: **Maute, Hans-Jürgen, Dipl.-Ing.**
**TELEFUNKEN electronic GmbH Theresienstrasse 2**
**D-7100 Heilbronn(DE)**

(54) **Tuner für wenigstens zwei Frequenzbereiche.**

(57) Bei einem Tuner für die Bereiche UHF und VHF ist für den hohen Frequenzbereich eine selbstschwingende Mischstufe vorgesehen, während für den oder die niedrigeren Frequenzbereiche eine davon getrennte fremdgesteuerte Mischstufe verwendet wird. Um den Schaltungsaufbau zu vereinfachen und eine erhöhte Ausnutzung der notwendigen Schaltungsmittel zu erreichen, wird die selbstschwingende Mischstufe bei Betrieb im niedrigeren Frequenzbereich als Oszillator umgeschaltet. Hierzu wird in einen für den UHF-Bereich vorgesehenen Schwingkreis 7 mit Hilfe eines ersten Schalters 23 eine zusätzliche Induktivität 13, 14, 15 eingeschaltet, die die Resonanzfrequenz entsprechend erniedrigt. Außerdem wird über wenigstens eine zusätzliche Rückkoppelleitung 26, 30 und einen darin vorgesehenen Schalter 27, 31 für den bzw. die niedrigeren Frequenzbereiche eine zusätzliche Rückkopplung geschaffen, die den Oszillator sicher schwingen läßt.

EP 0 129 154 A2

./...

Selektive Vorstufe BRF VHF I/III

Bandfilter BRF VHF I/III

VHF-Mischstufe UHF-ZF-Verstärker

UHF ZF

US BRF-VHF

UB/US VHF III

US-HB

US-HB

US V/III

UHF-ZF

ZF

TEG-83/04

7,

Ò129154

22.2.1983
Bt/sta

TELEFUNKEN electronic GmbH
Frankfurt/Main

## Tuner für wenigstens zwei Frequenzbereiche

Die Erfindung betrifft einen Tuner gemäß dem Oberbegriff des ersten Anspruchs.

Bei einem bekannten Tuner dieser Art (Funk-Technik 3/1976, Seiten 52-54) ist eine allen Frequenzbereichen gemeinsame Vorstufe vorgesehen, der ein eigenständiges UHF-Bandfilter und ein auf die Bereiche VHF I und VHF III umschaltbares Bandfilter nachgeschaltet sind. Bei UHF-Betrieb wird die selektierte UHF-Energie auf den Eingang einer selbstschwingenden UHF-Mischstufe geführt, die einen nach Art eines lambda/2-Resonanzkreises aufgebauten Schwingkreis für die Erzeugung der UHF-Oszillatorfrequenz aufweist. Die am Kollektor ausgekoppelte Zwischenfrequenz wird einem MOS-FET-Transistor zur Nachverstärkung zugeführt. Dieser MOS-FET arbeitet bei VHF-Betrieb und bei abgeschalteter UHF-Mischstufe als fremdgesteuerte Mischstufe für die selektierten VHF-Signale. Dabei wird die Oszillatorfrequenz für die VHF-Bereiche durch einen eigenständigen Oszillator erzeugt. Dieser VHF-Oszillator ist bei UHF-Betrieb abgeschaltet. Von Nachteil ist hierbei der hohe Schaltungsmittelaufwand für die selbstschwingende Mischstufe und die fremdgesteuerte Mischstufe mit ihrem separaten Oszillator.

Der Erfindung liegt die Aufgabe zugrunde, bei einem Tuner gemäß dem Oberbegriff des ersten Patentanspruchs Maßnahmen zu treffen, durch welche ein vereinfachter Schaltungsaufbau und eine Verminderung besonders der aktiven Verstärkerelemente erreicht wird.

Die Lösung dieser Aufgabe erfolgt gemäß der Erfindung durch die kennzeichnenden Merkmale des ersten Patentanspruchs.

Bei einem Schaltungsaufbau gemäß der Erfindung kann der getrennte Oszillator für die VHF-Bereiche entfallen, nachdem seine Funktion durch entsprechendes Umschalten der ohnehin selbstschwingenden Mischstufe auf einen niedrigeren Frequenzbereich übernommen wird. Hierzu braucht gemäß einer vorteilhaften Ausgestaltung lediglich in den ohnehin vorhandenen, nach Art eines lambda/2-Resonanzkreises aufgebauten Oszillator-Schwingkreis der UHF-Mischstufe nur eine zusätzliche Induktivität eingeschaltet und ein weiterer Rückkopplungsweg von diesem Schwingkreis zum Eingang der selbstschwingenden Mischstufe geschaffen zu werden. Die Auskopplung der VHF-Oszillatorfrequenz erfolgt dann aus dem Bereich der zusätzlich eingeschalteten Induktivität.

Vorteilhafte weitere Ausgestaltungen der Erfindung sind in den übrigen Ansprüchen angegeben.

Die Erfindung ist nachfolgend anhand der prinzipiellen Schaltungsskizze eines als Ausführungsbeispiel dargestellten Tuners für die UHF- und VHF-Bereiche näher erläutert.

Bei einem Tuner für Fernsehgeräte wird in einer aktiven Vorstufe ein aus den an einem Antennenanschluß 2 anstehenden Signalen durch entsprechende Umschaltungen ein UHF- oder VHF-Signal selektiert. Das vorverstärkte Signal wird auf

TEG-83/04 — 3 — 22.2.1983
Bt/sta

0129154

eine Bandfilteranordnung 2 geführt, die Selektionsmittel für den UHF und umschaltbare Selektionsmittel für den VHF I oder VHF III-Bereich aufweist. Bei UHF-Betrieb werden die selektierten UHF-Eingangssignale über einen Koppelkondensator auf den Emitteranschluß 4 eines Mischtransistors 5 geschaltet, der bei UHF-Betrieb mit Hilfe eines an den Kollektor 6 des Transistors 5 angeschalteten, nach Art eines lambda/2-Resonanzkreises aufgebauten Schwingkreises 7 und einen von dessen Hochpunkt 8 zum Emitter 4 geschalteten Rückkopplungskondensator 9 als selbstschwingende UHF-Mischstufe betrieben ist. Die entstehende UHF-Zwischenfrequenz wird am Kollektor 6 des Transistors 5 über ein ZF-Filter 10 ausgekoppelt und auf den Eingang 11 eines UHF-ZF-Verstärkers, der gleichzeitig bei VHF-Betrieb als fremderregte VHF-Mischstufe 12 arbeitet geführt.

Bei VHF-Betrieb werden die in der Bandfilteranordnung 3 selektierten VHF-Signale auf den Eingang 11 der fremdgesteuerten VHF-Mischstufe 12 geschaltet. Für die Erzeugung des notwendigen VHF-Oszillatorsignals wird in diesem Fall die selbstschwingende UHF-Mischstufe durch teilweises Auftrennen der UHF-Schwingkreise 7 und Anschalten einer für die VHF-Bereich gegebenenfalls aus mehreren Spulen 13, 14, 15 aufgebauten Induktivität und durch zusätzlich zum Rückkopplungskondensator 9 geschaffene Rückkopplung zu einem im VHF-Bereich schwingenden Oszillator umgeschaltet. Da der Koppelkondensator 16 zwischen dem UHF-Bandfilterteil und dem Emitter nur für den hohen Frequenzbereich bemessen zu sein braucht, wird bei VHF-Betrieb durch die Belastung mit dem dann sehr niederohmigen UHF-Bandfilter praktisch keine VHF-Engergie abgeleitet. Die VHF-Oszillatorenergie wird an der Spule 13 ausgekoppelt und ebenfalls an den Eingang 11 der VHF-Mischstufe geführt.

Der Schwingkreis 7 weist eine Leitungsinduktivität 17 auf, die einendig mit dem Hochpunkt 8 verbunden ist und deren anderes Ende einerseits über die Serienschaltung aus einer Fußpunktkapazität 18 und einem Phasendreherkondensator 19 sowie die Serienschaltung aus einer ersten Abgleichspule 20 und einer als Kapazitätsdiode ausgebildeten Abstimmkapazität 21 jeweils an Masse angeschaltet ist. Parallel zur Kapazitätsdiode 21 liegt die Serienschaltung aus einer zweiten Abgleichspule 22 und einer Schaltdiode 23 als einem ersten Schalter. Zur gleichstrommäßigen Abblockung ist der Schaltdiode 23 ein Kondensator vorgeschaltet, so daß die Schaltdiode 23 gleichstrommäßig gegenüber der Kapazitätsdiode 21 entkoppelt ist. Der Schaltdiode 23 wird über einen Widerstand 24 eine Schaltspannung zugeführt, wenn eine Umschaltung von UHF- auf VHF-Betrieb vorgenommen wird. Bei UHF-Betrieb ist die Schaltdiode 23 als erster Schalter geschlossen, so daß die zweite Abgleichspule 22 hochfrequenzmäßig an Masse liegt. Dadurch ist die über eine weitere, als zweite Abstimmkapazität dienende Kapazitätsdiode 25 an die Abgleichspule 22 angeschlossene Induktivität 13, 14, 15 kurzgeschlossen und damit ohne Einfluß auf die selbstschwingende UHF-Mischstufe. Für den Betrieb als VHF-Oszillator wird die Schaltdiode 23 gesperrt und damit der Kurzschluß der Induktivität 13, 14, 15 aufgehoben. Der Schwingkreis 7 wird dadurch um diese Induktivität erweitert und seine Resonanzfrequenz bei entsprechender Bemessung in den Frequenzbereich des VHF-Bandes I oder des VHF-Bandes III verschoben. In diesen Frequenzbereichen reicht die Rückkopplung für ein sicheres Schwingen als VHF-Oszillator über den Rückkopplungskondensator 9 nicht aus. Es ist daher für den VHF-III-Bereich eine erste zusätzliche Rückkoppelleitung 26 vorgesehen, welche vom Verbindungspunkt des Fußpunktkondensators 18 mit dem Phasendreherkondensator 19 über eine weitere Schaltdiode 27 als zweiter Schalter zum Eingang bzw. Emitter
des Transistors 5 führt. Die Schaltdiode 27 ist durchgeschaltet, wenn bei gesperrter Schaltdiode 23 lediglich die
Induktivität 13 für den VHF-Bereich III eingeschaltet ist.
Die Abschaltung der weiteren Spulen 14, 15 erfolgt dabei
über eine Schaltdiode 28 als einen fünften Schalter, der
dann durchgeschaltet ist. Wird der Tuner nur für die Bereich
UHF und VHF III ausgelegt, dann kann das masseseitige Ende
der Spule 13 gemäß der strichlierten Linie unmittelbar an
Masse geschaltet sein. Die zusätzliche Rückkoppelleitung 26
sorgt bei durchgeschalteter Schaltdiode 27 für eine ausreichende, phasenrichtige Rückkopplung im VHF-III-Bereich.
Bei gesperrter Schaltdiode 27 wird über die geringe Sperrschichtkapazität der Schaltdiode 27 im UHF-Betrieb eine
zusätzliche Rückkopplung erreicht, die aufgrund der Strom-
und Spannungsverteilung im Schwingkreis 7 bei niedrigen
Frequenzen des UHF-Bereichs eine erwünschte Verstärkung der
Rückkopplung bewirkt. Dieser Koppelpunkt ist unabhängig von
der Kopplung über den Rückkopplungskondensator 9, so daß die
Schwingstabilität bei niedrigen UHF-Frequenzen für sich
eingestellt werden kann.

Bei Betrieb im VHF-I-Bereich bleibt die Schaltdiode 23
gesperrt und auch die Schaltdiode 28 wird in den Sperrzustand durch Anlegen einer entsprechenden Spannung über den
Widerstand 29 geschaltet. Ein weiterer Rückkopplungsweg 30
führt dann von einer Anzapfung zwischen den Spulen 14 und 15
sowie über eine weitere Schaltdiode 31 als dritter Schalter
ebenfalls zum Eingang 4 des Transistors 5. Diese Schaltdiode
31 ist dann durchgeschaltet, d.h. der entsprechende Schalter
geschlossen. Hierdurch wird Oszillatorenergie wiederum zum
Eingang 4 zurückgekoppelt und die Schwingung des Oszillators
im VHF-I-Bereich sichergestellt. Mit der Abblock-Induktivität 32 liegt auch eine weitere Schaltdiode 33 als vierter Schalter in Serie dem die weiteren Tiefpaßglieder vorgeschaltet sind.

Um eine automatische Ein- bzw. Ausschaltung der Rückkopplungswege 26 und 30 zu erreichen, erfolgt die Stromeinspeisung zum Emitter 4 des Transistors 5 hin durch Entkopplungswiderstände 34, die je nach gewünschtem Frequenzband wahlweise an eine Stromquelle UB, die zugleich die Schaltspannung US liefert, anschaltbar sind. Über den jeweils angeschalteten Entkopplungswiderstand 34 fließt dann der Arbeitsstrom für den Transistor 5, wobei die zugehörige
Schaltdiode 27 oder 31 oder 33 durchgeschaltet, der entsprechende Schalter also geschlossen ist. Über die Schaltdioden 27 bzw. 31 wird dann jeweils der entsprechende
Rückkopplungsweg 26 bzw. 30 für die VHF-Bereiche III bzw. I
freigeschaltet. Bei einer Stromversorgung über die Schaltdiode 33 wird die Stromversorgung für UHF-Betrieb vorgenommen. Über die jeweils durchgeschaltete Schaltdiode 27,
31, 33 werden dabei gleichzeitig jeweils die beiden anderen
Schaltdioden gesperrt, nachdem ihre Entkopplungswiderstände
über relativ hochohmige Widerstände 35 an Masse angeschlossen sind. Die zweite Abstimmkapazität 25 dient im übrigen
zur Vergrößerung des Abstimmbereiches, wie er insbesondere
für das Durchstimmen im VHF-I-Bereich erforderlich ist. Sie
sind gleichstrommäßig parallel geschaltet.

0129154

TELEFUNKEN electronic GmbH
Frankfurt/Main


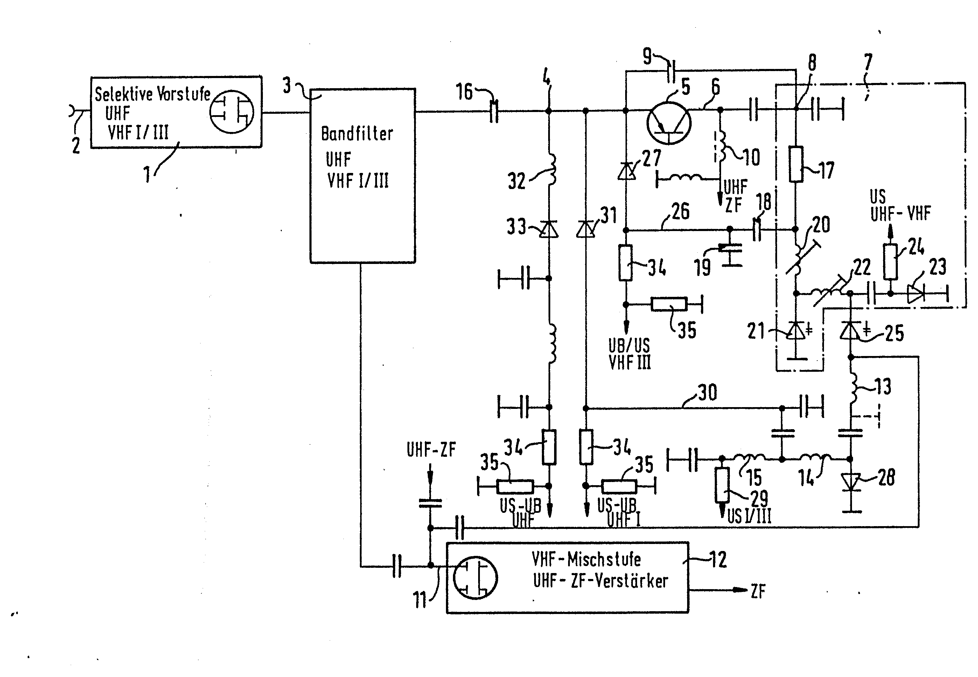

Patentansprüche

1. Tuner für wenigstens zwei Frequenzbereiche, insbesondere
Kombituner für UHF- und VHF-Bereiche, mit einer selbstschwingenden Mischstufe für den hohen Frequenzbereich und
mit einer fremdgesteuerten Mischstufe für den niedrigen
Frequenzbereich, der Ozillatorenergie aus einem separaten
Oszillator zugeführt wird, dadurch gekennzeichnet, daß die
selbstschwingende Mischstufe bei Betrieb im niedrigen Frequenzbereich als Oszillator für den niedrigen Frequenzbereich umgeschaltet ist.

2. Tuner nach Anspruch 1, dadurch gekennzeichnet, daß die
selbstschwingende Mischstufe einen nach Art eines lambda/2-
Resonanzkreises aufgebauten Schwingkreis (7) aufweist, bei
dem eine niederohmige  Leitungsinduktivität (17) in Serie
mit einer ersten hochohmigen Abgleichspule (20) und einer
Abstimmkapazität (21) gegen Masse geschaltet ist und parallel zur Abstimmkapazität (21) eine zweite Abgleichspule (22)
liegt, deren masseseitiger Anschluß über einen ersten Schalter (23) an Masse angeschlossen ist, daß parallel zum ersten
Schalter (23) eine weitere Induktivität (13, 14, 15) liegt,
die die Resonanzfrequenz des Schwingkreises bei geöffnetem
ersten Schalter (23)erniedrigt daß vom Schwingkreis (7) nach
der Leitungsinduktivität (17) eine Rückkoppelleitung (26,30) über einen zweiten Schalter (27, 31) an den Eingang (4) der Mischstufe angeschaltet ist und daß beide Schalter (27 bzw. 31 und 23) jeweils den entgegengesetzten Schaltzustand aufweisen.

3. Tuner nach Anspruch 1 oder 2, dadurch gekennzeichnet, daß in Serie mit einem parallel zu der ersten Abgleichspule (20) und der Abstimmkapazität (21) liegenden Fußpunktkondensator (18) ein Phasendreherkondensator (19) gegen Masse geschaltet ist und daß eine Rüclkoppelleitung (26) vom Verbindungspunkt der beiden Kondensatoren (18, 19) wegführt.

4. Tuner nach Anspruch 1 oder einem der folgenden, dadurch gekennzeichnet, daß eine Rückkoppelleitung (30) von einer Anzapfung der Induktivität (14, 15) über einen dritten Schalter (31) an den Emitter (4) angeschlossen ist und daß die übrigen Schalter (23, 27) geöffnet sind, wenn dieser dritte Schalter (31) geschlossen ist.

5. Tuner nach Anspruch 4, dadurch gekennzeichnet, daß der dritte Schalter (31) direkt an den Emitter (4) geschaltet ist.

6. Tuner nach Anspruch 5, dadurch gekennzeichnet, daß der zweite Schalter (27) direkt an den Emitter angeschlossen ist.

7.Tuner nach Anspruch 5 oder 6, dadurch gekennzeichnet, daß die Abblockinduktivität (32) eine an den Eingang der selbstschwingenden Mischstufe angeschaltete Spule eines Tiefpasses für die UHF-Zwischenfrequenz ist.

Ò129154

8. Tuner nach Anspruch 4 oder einem der folgenden, dadurch
gekennzeichnet, daß der vierte Schalter (33) über eine
Induktivität (32) an den Emitter (4) angeschlossen ist.

9. Tuner nach Anspruch 1 oder einem der folgenden, dadurch
gekennzeichnet, daß die dem Emitter (4) als Mischstufen-
Transistor (5) abgewandten Anschlüsse des zweiten, dritten
und vierten Schalters (27, 31, 33) über je einen Entkopplungswiderstand (34) wahlweise an eine Stromquelle (UB)
anschließbar sind.

10. Tuner nach Anspruch 1 oder einem der folgenden, dadurch
gekennzeichnet, daß ein Abgriff der Induktivität (13, 14)
über einen fünften Schalter (28) an Masse anschaltbar ist.

11. Tuner nach Anspruch 1 oder einem der folgenden, dadurch
gekennzeichnet, daß die Schalter (27, 31, 33) Schaltdioden
sind und gleichstrommäßig mit dem Emitter (4) verbunden
sind.

12. Tuner nach Anspruch 9 oder einem der folgenden, dadurch
gekennzeichnet, daß die den Schaltern (27, 31, 33) abgewandten Anschlüsse der Entkopplungswiderstände (34) über
hochohmige Widerstände (35) an Masse angeschlossen sind.

13. Tuner nach Anspruch 1 oder einem der folgenden, dadurch
gekennzeichnet, daß in Serie mit der Induktivität (13, 14,
15) eine zweite Abstimmkapazität (25) geschaltet ist.

14. Tuner nach Anspruch 1 oder einem der folgenden, dadurch gekennzeichnet, daß die Abstimmkapazität (21, 25) Kapazitätsdioden sind, die gleichstrommäßig parallel geschaltet sind.

15. Tuner nach Anspruch 1 oder einem der folgenden, dadurch gekennzeichnet, daß bei Verwendung eines lambda/2-Leitungskreises (in Bügeltechnik) die Hochpunktpapazität aufgeteilt und eine Teilkapazität zur Rückkopplung des VHF-Signals verwendet wird.

0129154

Selektive Vorstufe UHF VHF I/III

Bandfilter UHF VHF I/III

VHF-Mischstufe UHF-ZF-Verstärker

US UHF-VHF

UHF ZF

UB/US VHF III

US I/III

US-UB UHF I

US-UB UHF

UHF-ZF

ZF